# EUROPÄISCHE PATENTSCHRIFT

(11) **EP 0 492 095 B1**
(45) Veröffentlichungstag und Bekanntmachung des Hinweises auf die Patenterteilung: **15.12.1993**
(21) Anmeldenummer: 91118821.7
(22) Anmeldetag: 04.11.1991
(51) Int. Cl.: B23K 1/20, H05K 3/34

(54) **Verfahren und Vorrichtung zur Verarbeitung von elektronischen Flachbaugruppen, insbesondere mit Bauelementen bestückten Leiterplatten**
Method and apparatus for machining circuit boards, in particular circuit boards with surface-mounted components
Méthode et appareillage d'usinage de cartes à circuits imprimés, en particulier de cartes équipées d'éléments de surface

(30) Priorität: 21.12.1990 DE 4041270
(43) Veröffentlichungstag der Anmeldung: 01.07.1992
(73) Patentinhaber: WLS KARL-HEINZ GRASMANN, D-97906 Faulbach (DE)
(72) Erfinder: Liedke, Volker, W-8751 Elsenfeld/Eichelsbach (DE); Grasmann, Karl-Heinz, W-6985 Stadtprozelten (DE); Albrecht, Hans-Jürgen, O-1093 Berlin (DE); Wittrich, Harald, O-1122 Berlin (DE); John, Wilfred, O-1153 Berlin (DE); Scheel, Wolfgang, O-1020 Berlin (DE)

(56) Entgegenhaltungen:
- EP-A- 0 371 693
- EP-A- 0 427 020
- DE-U- 8 520 254

## Beschreibung

Die Erfindung bezieht sich auf ein Verfahren zum Löten von elektronischen Flachbaugruppen, insbesondere mit Bauelementen bestückten Leiterplatten gemäß dem Oberbegriff von Patentanspruch 1 sowie auf eine Vorrichtung zur Durchführung dieses Verfahrens gemäß dem Oberbegriff von Patentanspruch 20.

Obwohl die Erfindung grundsätzlich zum Löten von elektronischen Flachbaugruppen beliebiger Art geeignet ist, wird sie im folgenden anhand des bevorzugten Anwendungsgebietes, nämlich des Lötens von mit Bauelementen bestückten Leiterplatten, erläutert. Dabei kommen sowohl eine Bestückung mit Nacktship-(COB)Bauelementen, mit steckbaren (THM) Bauelementen und mit aufsetzbaren (SMD) Bauelementen als auch eine Gemischtbestückung in Frage.

Der Anteil von komplexen elektronischen Flachbaugruppen mit hohen Zuverlässigkeitsanforderungen steigt ständig. Dabei müssen SMD- und THM-Bauformen auf einer Leiterplatte einzeln oder in Kombination als gemischtbestückte Baugruppe verarbeitet werden. Hierzu werden die Bauelemente mittels eines geeigneten, meistens automatisierten Bestückungsverfahrens auf den Lötanschlußflächen der Leiterplatte plaziert. Bei reinen SMD-Baugruppen erfolgt die Fixierung der Bauelemente überwiegend mit Hilfe von Lotpasten. Bei gemischtbestückten Baugruppen mit SMD- und THM-Bauelementen werden die THM-Bauelemente formschlüssig fixiert und die SMD-Bauelemente auf der Lötseite mittels eines geeigneten Klebers fixiert. Zur Herstellung des stoffschlüssigen Verbundes zwischen den Lötanschlußflächen der Bauelemente und der Leiterplatte ist es notwendig, daß die Lötanschlußflächen während des eigentlichen Lötprozesses vom Lot benetzt werden können. Häufig und üblicherweise befinden sich jedoch auf den Lötanschlußflächen sogenannte Passivschichten, bei denen es sich um Oxidschichten und organische und/oder anorganische Kontaminationsschichten handelt. Diese Passivschichten behindern den Zutritt des Lotes zu den Lötanschlußflächen und müssen daher üblicherweise dekapiert werden, d.h. vom metallischen Untergrund entfernt werden.

Es ist daher grundsätzlich bekannt, vor dem eigentlichen Lötprozeß einen Dekapierungsprozeß durchzuführen. Dementsprechend weisen bekannte Vorrichtungen außer einer Löteinrichtung, mittels derer die Lötanschlußflächen mit flüssigem Lot benetzt werden, eine Dekapierungseinrichtung auf, mittels derer die auf den Lötanschlußflächen zumindest vorhandenen Oxidschichten weitgehend entfernt werden.

Es ist bekannt, das Dekapieren mittels eines Flußmittels durchzuführen, das mittels einer eine Flußmittelauftragseinrichtung aufweisenden Dekapierungseinrichtung auf die Fügeteile aufgebracht wird. Das Flußmittel reagiert mit den Passivschichten und löst diese beispielsweise durch Komplexbildung. Darüber hinaus hat es die Aufgabe, die Neubildung der Passivschichten bis zur Benetzung mit flüssigem Lot zu verhindern. Außerdem kann es die Oberflächenspannung des Lotes vermindern und einer Brückenbildung zwischen benachbarten Lötstellen vorbeugen, und schließlich verzögert das Flußmittel die Bildung von Oxidhäuten auf den frischen Lötstellen, damit diese sich in der gewünschten Konfiguration ausbilden können.

Flußmittelrückstände können jedoch die elektrische Funktion der Flachbaugruppe beeinträchtigen und wirken korrosiv auf Bauelemente und Leiterplatte. Um eine sichere elektrische Funktion der Flachbaugruppen zu gewährleisten, ist es daher notwendig, die Flußmittelrückstände nach dem Löten in einem nachgeordneten Reinigungsprozeß naßchemich zu entfernen. Üblich war bisher ein Reinigungsbad aus fluorierten Chlor-Kohlenwasserstoffen (FCKW) oder chlorierten Kohlenwasserstoffen (CKW). Die Bestrebungen, die Umweltbelastung durch FCKW- oder CKW-haltige Fluide einzuschränken, haben zu hohen Investitionen hinsichtlich der Abluft- und Abwasserreinigung geführt, die Lötverfahren unter Einsatz von Flußmittel empfindlich verteuern.

Es ist daher anzustreben, flußmittelarme bzw. flußmittelfreie Verfahren zum Löten von elektronischen Flachbaugruppen anzuwenden.

Bekannt ist ein Verfahren zum Löten von elektronischen Flachbaugruppen (DE-U-85 20 254), bei dem die Dekapierung mit Hilfe eines Schutzgases erfolgt, das Oxidschichtenreduzierend wirkt und bei dem es sich vorzugsweise um ein Stickstoff-Wasserstoff-Gemisch handelt. Die Flachbaugruppe wird diesem Schutzgas in einer der Löteinrichtung vorgeschalteten Begasungskammer ausgesetzt, die in diesem bekannten Fall die Dekapierungseinrichtung bildet. Wegen der Oxidschichten-reduzierenden Wirkung des Schutzgases soll dadurch ein flußmittelfreies Löten der Flachbaugruppen möglich sein. Schwierigkeiten können dabei jedoch verursacht sein durch die reduzierende Wirkung, die sich nicht auf die Oxidschichten beschränkt, durch die Maßnahmen, die notwendig sind, um der Bildung von explosiven Luft-Schutzgasgemischen vorzubeugen, und durch die notwendigen hohen Prozeßtemperaturen.

Der Erfindung liegt die Aufgabe zugrunde, ein Verfahren gemäß dem Oberbegriff von Patentanspruch 1 zum Löten von elektronischen Flachbaugruppen zu schaffen, das einen Verzicht auf unterstützende Dekapierungsmittel in Form von Flußmitteln erlaubt sowie die bei Flußmitteleinsatz erforderliche Reinigungsnachbehandlung gelöteter Flachbaugruppen überflüssig macht. Ferner soll die Vorrichtung gemäß dem Oberbegriff von Patentanspruch 20 derart weitergebildet werden, daß sie zur Durchführung des neuen Verfahrens geeignet ist.

Diese Aufgabe wird hinsichtlich des Verfahrens erfindungs gemäß dadurch gelöst, daß während des Dekapierungsprozesses zunächst in Fehlstellen der Oxidschichten ein kondensationsfähiger Hilfsstoff zur Adsorption gebracht und in den Fehlstellen zumindest teilweise kondensiert wird und danach die Oxidschichten einer derart schnellen Erwärmung ausgesetzt werden, daß der in den Fehlstellen kondensierte Hilfsstoff explosionsartig verdampft und dadurch die Oxidschicht aufbricht und vom metallischen Untergrund absprengt.

Oxidische Schichtstrukturen weisen im allgemeinen eine Häufung dreidimensionaler Schichtfehler auf, die u. a. mit der Schichtdicke zunehmen können. Die Gesamtoberfläche dieser dreidimensionalen Schichtfehler in Form von mikroskopisch kleinen Profilen, Spalten und Löchern in der ansonsten geschlossenen Oberfläche übersteigt die ebene Projektionsfläche einer Lötanschlußfläche um ein Vielfaches. Bei der Erfindung werden nun diese Fehlstellen dazu ausgenutzt, an deren Oberflächen einen zunächst gasförmigen Hilfsstoff zu adsorbieren, der danach in den Fehlstellen zumindest teilweise kondensiert und die Fehlstellen dadurch mit Flüssigkeit füllt. Wenn dann später den Oxidschichten schnell Wärme zugeführt wird, verdampft die Flüssigkeit in den Fehlstellen schlagartig. Dies ist zwangsläufig von einer starken Volumenvergrößerung des Hilfsstoffes begleitet. Sofern die Volumenzunahme schnell genug erfolgt, baut sich innerhalb der Fehlstellen ein so hoher Druck auf, daß dieser die Oxidschicht aufsprengt und - unterstützt durch die Sprödigkeit der Oxidschicht und der lateralen Haftfestigkeitsunterschiede zum Grundwerkstoff - vom metallischen Untergrund der betrachteten Lötanschlußfläche absprengt. Diese wird dadurch in ihren virginen, metallurgisch reaktionsfähigen Zustand gebracht, so daß, wenn während des Lötprozesses Lot auf diese virginen Oberflächen trifft, eine ungestörte Anpassung, Benetzung und Grenzflächenreaktion zwischen dem Festkörper, d.h. der Lotanschlußfläche, und dem flüssigen Lot erfolgen kann.

Wirkmechanismus des vorstehend beschriebenen erfindungsgemäßen Verfahrens ist somit die schnelle Volumenexpansion des in den dreidimensionalen Schichtfehlern der Oxidschicht absorbierten und kondensierten Hilfsstoffes. Das Verfahren muß demzufolge so geführt werden, daß es dem Hilfsstoff ermöglicht wird, in gasförmiger Phase in die Fehlstellen einzudringen und dort adsorbiert zu werden, daß danach eine Kondensation des Hilfsstoffes in den Fehlstellen erfolgt und daß schließlich genug Wärme zum kondensierten Hilfsstoff gelangt, damit dessen Volumen explosionsartig zunimmt. Diese Bedingungen für die Verfahrensführung sind verhältnismäßig einfach zu erfüllen: Sofern die freie Oberfläche der Oxidschicht hinreichend hydrophil ist, reicht es aus, die Lötanschlußflächen einer den Hilfsstoff enthaltenden Gasatmosphäre unter geeignetem Druck und bei geeigneter Temperatur auszusetzen, damit der Hilfsstoff in die Fehlstellen eindringt, dort adsorbiert wird und schließlich kondensiert. Auch die erforderliche schnelle Erwärmung der Oxidschichten stellt kein grundsätzlich schwieriges Problem dar.

Beim erfindungsgemäßen Vorgehen erfolgt die Dekapierung der Oxidschichten durch physikalisches Absprengen derselben im Mikrobereich. Ein Flußmittel ist hierzu nicht erforderlich. Das erfindungsgemäße Verfahren ermöglicht somit ein flußmittelfreies Löten. Chemische Reaktionsprodukte fallen bei dieser Art des Dekapierens nicht an, so daß sie weder beseitigt werden müssen, noch zu Lötfehlern führen können. Da der Wirkmechanismus spezielle Struktureigenschaften der Oxidschichten ausnutzt, werden die unter der Oxidschicht liegenden Grundwerkstoffoberflächen beim Dekapieren nicht angegriffen. Schließlich ist zu beachten, daß eine Oxidschicht, je älter und je dicker sie ist, um so mehr Fehlstellen aufweist, in die der expansionsfähige Hilfsstoff eingebracht werden kann. Dies bedeutet mit anderen Worten, daß eine Oxidschicht in dem Maße, wie sie dicker und störender wirkt, zugleich immer besser auf erfindungsgemäß vorgesehene Weise angreifbar und abtragbar wird. Hierin liegt ein deutlicher Unterschied zum naßchemischen Dekapieren mittels eines Flußmittels oder auch zum Dekapieren mittels eines Oxidschichten-reduzierenden Schutzgases.

Der verwendete Hilfsstoff soll möglichst ein geringes Molekulargewicht haben und polar sein, damit er im gasförmigen Zustand in die Fehlstellen diffundieren kann und dort adsorbiert wird. Der Siedepunkt des Hilfsstoffes liegt vorzugsweise oberhalb der Raumtemperatur.

Geeignete Hilfsstoffe sind Wasser, Methanol, Aceton und Äthanol, wobei jedoch diese Aufzählung der Hilfsstoffe nicht abschließend ist.

Vorzugsweise wird die gesamte bestückte Flachbaugruppe einer den Hilfsstoff in gasförmiger Phase enthaltenden Gasatmosphäre ausgesetzt, bei der es sich um Luft mit einem Gehalt an Wasser als Hilfsstoff handeln kann. Die Zustandsbedingungen (Druck, Temperatur, relative Feuchte) müssen derart sein, daß der Hilfsstoff in gasförmiger Phase in die durch die Fehlstellen gebildeten Poren eindringen und dort adsorbiert werden kann. Eine frühzeitige Tropfenbildung auf der Oberfläche der Oxidschicht könnte dazu führen, daß die Poren durch die Tropfenbildung verschlossen werden und der gasförmige Hilfsstoff nicht in die Fehlstellen diffundieren kann. Eine solche frühzeitige Tropfenbildung ist daher unzweckmäßig.

Das Gasgemisch aus Luft und dem Hilfsstoff hat, insbesondere wenn der Hilfsstoff Wasser ist, den großen Vorteil der einfachen Bereitstellung dieser Gasatmosphäre und der maximal möglichen Umweltverträglichkeit. Es kommt natürlich auch eine reine Hilfsstoff-Atmosphäre in Frage, beispielsweise eine Atmosphäre aus 100 % Wasserdampf.

Der in den Fehlstellen kondensierte Hilfsstoff soll bei dem erfindungsgemäßen Verfahren schlagartig bzw. explosionsartig verdampfen. Dies setzt voraus, daß zu dem Zeitpunkt, zu dem die schnelle Erwärmung erfolgt, noch eine hinreichende Flüssigkeitsmenge des Hilfsstoffes in der Oxidschicht vorhanden ist. Verhindert werden muß daher, daß der kondensierte Hilfsstoff vor dem schnellen Erwärmen allmählich verdampft und entweicht. Dem allmählichen Verdampfen des Hilfsstoffes kann auf einfache Weise dadurch vorgebeugt werden, daß die schnelle Erwärmung der Adsorption und Kondensation des Hilfsstoffes in geringem zeitlichem Abstand folgt und/oder daß die Fügepartner nach der Kondensation des Hilfsstoffes bis zur schnellen Erwärmung beispielsweise in einer Klimakammer solchen Zustandsbedingungen ausgesetzt sind, daß keine Verdampfung des Hilfsstoffes erfolgt.

Bei der schnellen Erwärmung der Flachbaugruppe und somit der Oxidschichten mit dem eingelagerten Hilfsstoff liegt der zeitliche Temperaturgradient in der Oxidschicht vorzugsweise über 50 K/s, insbesondere über 150 K/s. Auch wesentlich höhere zeitliche Temperaturgradienten von bis zu 500 K/s sind geeignet und realisierbar. Die Wärmezufuhr zum Zweck der schnellen Erwärmung kann mittels einer beliebigen, geeigneten Einrichtung erfolgen, beispielsweise mittels einer IR-Heizeinrichtung und mittels einer Laser-Heizeinrichtung. Sofern eine solche Heizeinrichtung zur Anwendung kommt, geschieht dies vorzugsweise in einer Schutzgasatmosphäre, damit die durch das Absprengen der Oxidschichten erzeugte Virginität der Lötanschlußflächen erhalten bleibt.

Die Wärmezufuhr zum Zweck der schnellen Erwärmung der Oxidschicht, d.h. deren Aufheizung, kann zeitlich unmittelbar vor dem Lötprozeß erfolgen. Alternativ kann sie auch in gewissem zeitlichen Abstand vor dem Lötprozeß durchgeführt werden, wobei dann allerdings die geschaffene, virgine Oberfläche vorzugsweise in einer Schutzgasatmosphäre bis zum Lötprozeß aufrechtgehalten werden muß.

In besonders vorteilhafter Ausbildung der Erfindung kann jedoch vorgesehen sein, daß die Erwärmung der Oxidschicht mit dem adsorbierten Hilfsstoff während des Lötprozesses durch im Lot enthaltene oder diesem zugeführte Wärmeenergie erfolgt. Der Lötprozeß erfordert ohnehin eine Wärmezufuhr zum Lot, damit dieses in flüssiger Phase vorliegt und die Lötanschlußflächen benetzen kann. Wenn - wie dies vorzugsweise vorgesehen ist - aus dieser Wärmezufuhr die Wärmemenge für die schnelle Erwärmung der Oxidschicht entnommen wird, ist zum schnellen Erwärmen kein vom Lötprozeß zeitlich abgesetzter Verfahrensschritt notwendig, sondern läuft dieser Verfahrensschritt ab, während die Lotanschlußflächen ohnehin unmittelbar vor und während der Benetzung mit dem flüssigem Lot erwärmt werden.

Auf vorstehend genannte Weise kann beispielsweise beim Laserlöten oder auch beim Widerstandsimpulslöten vorgegangen werden. Besonders vorteilhaft ist jedoch die Wärmezufuhr unmittelbar durch die Lotwelle beim Wellenlöten. Wenn das erfindungsgemäße Verfahren durchgeführt wird in Verbindung mit einem Wellenlötprozeß, kann dies in der Weise geschehen, daß die bestückte Flachbaugruppe auf die stehende Lotwelle aufgleitet, ohne daß zuvor die Oxidschichten von den Lötanschlußflächen entfernt worden sind, wobei jedoch in die Oxidschichten bereits der kondensierte Hilfsstoff eingebracht worden ist. Wenn ein bestimmtes Oberflächenelement einer Lötanschlußfläche beim Durchlaufen der Lotwelle betrachtet wird, so ergibt sich für dieses Oberflächenelement, daß es beim ersten Kontakt mit der Lotwelle schlagartig erwärmt wird, so daß die bereits beschriebene explosionsartige Volumenexpansion des Hilfsstoffes und Absprengung der Oxidschichten erfolgt. Die abgesprengten Oxidschichten werden von der Lotwelle weggespült. Die unter der abgesprengten Oxidschicht freigelegte, virgine Lötanschlußfläche wird ohne Zeitverzug von der Lotwelle abgedeckt, so daß die Lotwelle selber eine Schutzfluidfunktion erfüllt und beispielsweise eine erneute Oxidbildung ausgeschlossen ist. Zugleich mit dieser schützenden Abdeckung der virginen Lötanschlußflächen beginnt deren Benetzung durch das Lot.

Die vorstehend beschriebene Adsorption des gasförmigen Hilfsstoffes in den Fehlstellen setzt voraus, daß dieser in die Fehlstellen gelangen kann und daß die Oberflächen, an denen der Hilfsstoff adsorbiert werden soll, hinreichend hydrophil sind. Häufig sind jedoch die Oxidschichten auf den Lötanschlußflächen durch weitere Passivschichten organischer und/oder anorganischer Art verunreinigt, so daß die Oxidschichtoberflächen keine freien Bindungen aufweisen, weil diese durch Verunreinigungen abgesättigt sind, und hydrophob sind. Aus diesem Grunde ist in vorteilhafter Ausbildung der Erfindung vorgesehen, daß während des Dekapierungsprozesses vor der Adsorption des Hilfsstoffes eine Vorbehandlung zur Beseitigung von Passivschichten auf den Oxidschichten durchgeführt wird. Dadurch sollen die Poren in der Oxidschicht, soweit sie durch die Passivschichten verdeckt sind, freigelegt werden und soll die Oberfläche der Oxidschichten hydrophiliert werden.

Diese Hydrophilierung kann auf naßchemische Weise mit Hilfe eines Reinigungsmittels erfolgen, wobei es sich versteht, daß die Aggressivität dieses Reinigungsmittels und die dadurch verursachte Abfallstoffbelastung geringer sein kann als im Falle eines Flußmittels, das außer den organischen und anorganischen Kontaminationsschichten auch die Oxidschichten beseitigen soll.

In vorteilhafter Ausbildung der Erfindung ist vorgesehen, daß die Vorbehandlung mit Hilfe eines Plasmas erfolgt, dem die Lötanschlußflächen ausgesetzt werden. Eine Plasma-Vorbehandlung von Flachbaugruppen gehört aufgrund der deutschen Patentanmeldung DE-A-39 36 955.2 zum Stand der Technik, wobei in diesem zum Stand der Technik gehörenden Fall die vollständige Dekapierung einschließlich der Oxidschichten durch eine Plasma-Vorbehandlung angestrebt wird. Im Gegensatz dazu erfolgt im Rahmen der Erfindung die Plasma-Vorbehandlung zur Hydrophilierung und nicht zum Abtragen der Oxidschichten, so daß es auf eine reduzierende Wirkung des Plasmas nicht ankommt. Durch die Plasma-Vorbehandlung wird die Kavitation, d.h. das Freilegen vorhandener Topologiestörungen, im oxidischen Bereich potentiell und homogen unterstützt.

Als Prozeßgase für das Plasma eignen sich O₂, N₂, H₂, CO₂, N₂O und H₂O sowie insbesondere Luft, wobei vorzugsweise mit einem Niederdruckplasma gearbeitet wird.

Der durch die Hydrophilierung erhaltene Zustand soll auch noch zu dem Zeitpunkt vorliegen, zu dem die adsorptive Einlagerung des Hilfsstoffes erfolgt. Daher kann in vorteilhafter Ausbildung der Erfindung vorgesehen sein, daß zwischen der Plasma-Vorbehandlung und der adsorptiven Einlagerung des Hilfsstoffes eine Belüftung der Flachbaugruppe in kohlenwasserstofffreier Luft erfolgt. Sauerstofffreiheit ist zu diesem Zeitpunkt nicht erforderlich, da die Oxidschichten auf den Lötanschlußflächen ohnehin noch vorhanden sind. Allerdings hat sich gezeigt, daß auch eine mehrstündige Zwischenlagerung der Plasma-vorbehandelten Fügepartner unter Umgebungsbedingungen die Lötanschlußflächen noch nicht für die Folgebehandlung ungeeignet macht.

Im Hinblick auf die Vorrichtung wird die Aufgabe erfindungsgemäß gelöst durch die Vorrichtung gemäß Patentanspruch 20. Erfindungsgemäß weist die Vorrichtung zum Löten von elektronischen Flachbaugruppen eine Befeuchtungskammer auf, in der eine Gasatomosphäre vorhanden ist, die den gasförmigen, kondensationsfähigen Hilfsstoff enthält. Die Flachbaugruppe verweilt in dieser Befeuchtungskammer während einer steuerbaren Behandlungsdauer. Die Zustandsbedingungen der Gasatmosphäre sind derart einstellbar, daß der Hilfsstoff in den Oxidschichten auf den Lötanschlußflächen der Fügeteile absorbiert wird und zumindest teilweise kondensiert. Ferner zeichnet sich die erfindungsgemäße Vorrichtung durch eine Erwärmungseinrichtung aus, mittels derer im Anschluß an die Befeuchtung durch Adsorption und Kondensation des Hilfsstoffes die Oxidschichten schnell erwärmt werden. Die Befeuchtungskammer hat den Vorteil, daß die Zustandsbedingungen während der Befeuchtung hinreichend genau gesteuert werden können, so daß Störeinflüsse unterdrückt werden können und die Befeuchtung zu reproduzierbaren Ergebnissen führt.

Vorstehend ist bereits angegeben worden, daß der Befeuchtung, d.h. der Einlagerung des kondensierten Hilfsstoffes in die Fehlstellen der Oxidschichten, vorzugsweise und zweckmäßigerweise eine Plasma-Vorbehandlung vorausgeht. Diese Plasma-Vorbehandlung kann in der Befeuchtungskammer erfolgen, wobei diese dann derart betrieben wird, daß in ihr wahlweise die Gasatmosphäre oder eine Prozeßgas-Atmosphäre für die Plasma-Vorbehandlung hergestellt wird. Diese Ausbildung der Vorrichtung ermöglicht es insbesondere, das erfindungsgemäße Verfahren auch bei geringer Anzahl zu lötender Flachbaugruppen mit geringem vorrichtungsmäßigem Aufwand anzuwenden.

In vorteilhafter Ausbildung der Erfindung ist allerdings vorgesehen, daß die Dekapierungseinrichtung zusätzlich zu der Befeuchtungskammer eine Prozeßkammer zur Plasma-Vorbehandlung der Lötanschlußflächen aufweist.

In bevorzugter Ausbildung der erfindungsgemäßen Vorrichtung umfaßt dieser in Reihe hintereinander eine Evakuierungskammer, die Prozeßkammer zur Plasma-Vorbehandlung, eine Belüftungskammer, in der eine Belüftung der plasmavorbehandelten Flachbaugruppen mit kohlenwasserstofffreier Luft erfolgt, die Befeuchtungskammer sowie als Löteinrichtung eine Wellenlöteinrichtung, die zumindest eine stehende Lotwelle erzeugt, wobei alle vorstehend genannten Kammern als Durchlaufkammern ausgebildet sind und durch Schleusen voneinander trennbar sind. Dabei dient die Befeuchtungskammer zugleich als Vorheizeinrichtung für den Lötprozeß und bildet die Wellenlöteinrichtung gleichzeitig die Erwärmungseinrichtung für die Oxidschichten mit dem eingelagerten Hilfsstoff. Die Löteinrichtung ist allerdings nicht notwendigerweise eine Wellenlöteinrichtung; vielmehr kann sie beispielsweise auch eine Löteinrichtung mit einem ruhenden Lotbad oder eine Reflow-Löteinrichtung sein.

Weitere vorteilhafte Ausgestaltungen der Erfindung sind in den Unteransprüchen gekennzeichnet.

Ein Ausführungsbeispiel der Erfindung ist in den Zeichnungen dargestellt und wird im folgenden näher erläutert. Es zeigen:
Fig. 1 eine schematische Seitenansicht, teilweise im Schnitt, einer Vorrichtung zum Löten von elektronischen Flachbaugruppen;
Fig. 2 einen schematischen, ausschnittsweisen Längsschnitt durch eine Lötanschlußfläche mit Passivschichten; und
Fig. 3 eine schematische Darstellung zur Erläuterung der Vorgänge beim Auflaufen einer Leiterplatte auf eine Lotwelle.

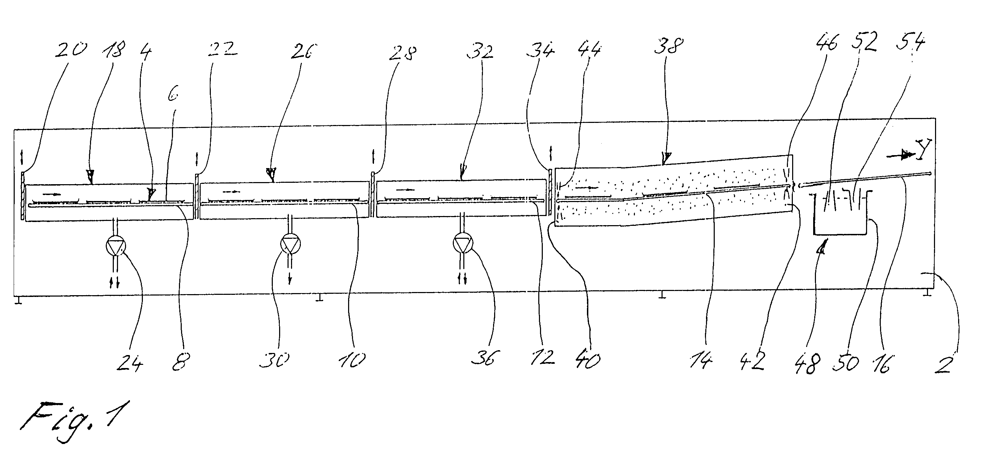

Die in Fig. 1 dargestellte Vorrichtung umfaßt ein Maschinengestell 2, das lediglich schematisch dargestellt ist und alle Einrichtungen der Vorrichtung trägt. Zu lötende Flachbaugruppen 4 durchlaufen die Vorrichtung von links nach rechts in Fig. 1. Jede Flachbaugruppe 4 umfaßt beim dargestellten Ausführungsbeispiel eine Leiterplatte 6, die mit nicht dargestellten Bauelementen bestückt ist, bei denen es sich beispielsweise um steckbare und/oder aufsetzbare Bauelemente handeln kann. Jede Leiterplatte 6 kann von einem nicht dargestellten Lötrahmen gehalten sein.

Der Transport der Leiterplatten 6 durch die Vorrichtung erfolgt mit Hilfe von aufeinanderfolgend angeordneten Transporteinrichtungen 8, 10, 12, 14 und 16, bei denen es sich beispielsweise um Riemen- oder Kettenfördereinrichtungen handelt, die an den seitlichen Rändern der Flachbaugruppen angreifen. Einzelheiten dieser Transporteinrichtungen werden hier nicht näher erläutert, da es auf deren Ausbildung für die Erfindung nicht ankommt. Die Transporteinrichtung 8 übergibt die transportierten Flachbaugruppen 6 zur Transporteinrichtung 10, diese übergibt zur Transporteinrichtung 12, letztere übergibt zur Transporteinrichtung 14 und diese übergibt zur Transporteinrichtung 16. Die Transporteinrichtungen 8, 10 und 12 transportieren die Flachbaugruppen 4 auf einer im wesentlichen horizontalen Bahn. Die durch die Transporteinrichtung 14 definierte Transportbahn steigt an ihrem hinteren Ende leicht an. Auch die Transporteinrichtung 16 definiert eine leicht ansteigende Transportbahn.

Die auf herkömmliche Weise bestückten Leiterplatten 6, die noch nicht dekapiert worden sind, werden zunächst in eine Evakuierungskammer 18 eingebracht, die sich am in Fig. 1 linken Ende der Vorrichtung befindet, an dem die Beschickung der Vorrichtung mit den Flachbaugruppen 4 auf beliebige, geeignete Weise erfolgt. Die Evakuierungskammer 18 ist als tunnelförmige Durchlaufkammer ausgebildet und weist dementsprechend an ihrem linken Ende einen Einlaß und an ihrem rechten Ende einen Auslaß auf. Der Einlaß ist verschließbar mittels einer ersten Schleuse 20, die beispielsweise als vertikal verschiebbare Platte ausgebildet ist. Der Auslaß der Evakuierungskammer 18 ist verschließbar mittels einer zweiten Schleuse 22, die ebenso wie die übrigen Schleusen der Vorrichtung auch als vertikal verschiebbare Platte ausgebildet sein kann. Innerhalb der Evakuierungskammer 18 ist die erste Transporteinrichtung 8 derart angeordnet, daß sie die Flachbaugruppen 4 in vorgegebener Weise vom Einlaß zum Auslaß durch die Evakuierungskammer 8 hindurch transportieren kann. Der Innenraum der Evakuierungskammer 18 ist angeschlossen an eine Vakuumpumpe 24, mit deren Hilfe die Evakuierungskammer 18 bei geschlossenen Schleusen 20 und 22 auf einen gewünschten Unterdruck evakuiert werden kann. Bei diesem Unterdruck handelt es sich beispielsweise um den Prozeßdruck von 30 bis 40 Pa innerhalb einer noch zu erläuternden Prozeßkammer 26 für eine Plasma-Vorbehandlung. Die Evakuierungskammer 18 ist ferner mit einem Belüftungssystem versehen, das es ermöglicht, den Druck im Inneren der Evakuierungskammer 18 wieder auf den Umgebungsdruck oder einen Druck im Bereich des Umgebungsdruckes zu erhöhen.

An die Evakuierungskammer 18 schließt sich die Prozeßkammer 26 für eine Plasma-Vorbehandlung an. Auch die Prozeßkammer 26 ist als Durchlaufkammer mit einem Einlaß und einem Auslaß versehen, wobei ihr Einlaß mittels derselben zweiten Schleuse 22 verschließbar ist, die als Verschluß des Auslasses der Evakuierungskammer 18 dient. Der Auslaß der Prozeßkammer 26 ist mittels einer dritten Schleuse 28 verschließbar. Innerhalb der Prozeßkammer 26 ist die zweite Transporteinrichtung 10 angeordnet, der die Flachbaugruppen 4 bei geschlossener erster und dritter Schleuse 20 bzw. 28 und geöffneter zweiter Schleuse 22 von der ersten Transporteinrichtung 24 übergeben werden. Die Prozeßkammer 26 ist an eine Vakuumpumpe 30 angeschlossen, mit deren Hilfe das Innere der Prozeßkammer 26 auf den Prozeßdruck von beispielsweise 30 bis 40 Pa evakuiert werden kann. Außerdem ist die Prozeßkammer 26 belüftbar. Die Belüftung der Prozeßkammer 26 wird allerdings lediglich beim Abschalten der gesamten Vorrichtung ausgeführt. Während des Betriebes steht die Prozeßkammer 26 stets unter Prozeßdruck und ist sie stets mit Prozeßgas gefüllt, da die Zufuhr von Flachbaugruppen 4 zur Prozeßkammer 26 und die Abfuhr der Flachbaugruppen aus dieser stets aus bzw. in Kammern erfolgt, die ebenfalls auf den Prozeßdruck evakuiert sind. Die Prozeßkammer 26 ist mit nicht dargestellten Vorrichtungen versehen, die es ermöglichen, innerhalb der Prozeßkammer 26 ein Niederdruck-Plasma zu erzeugen und aufrechtzuerhalten. Zu diesen nicht dargestellten Einrichtungen gehören die Gasanschlüsse, mit denen das Prozeßgas in die Prozeßkammer 26 eingeleitet und aus dieser abgeführt wird, Heizeinrichtungen, mit denen die Prozeßkammer 26 auf die Prozeßtemperatur gebracht wird, sowie Umwälzeinrichtungen für das Prozeßgas, die dieses im Kreislauf durch die Prozeßkammer 26 führen und ggf. eine Gasreinigungsanlage mit beispielsweise einem Adsorber aufweisen.

Innerhalb der Prozeßkammer wird im Betrieb ein Niederdruck-Plasma erzeugt und aufrechtgehalten, dessen Prozeßgas aus O₂, N₂, H₂, CO₂, N₂O, H₂O oder einer Kombination dieser Gase besteht. Das Prozeßgas kann aber auch Luft sein. Bei den nicht dargestellten Einrichtungen zur Anregung des Plasmas kann es sich beispielsweise um Magnetrone handeln, über die die Hochfrequenzenergie zur Erzeugung des Gasplasmas eingeleitet wird und die oberhalb der Transporteinrichtung 10 im Bereich der oberen Wand der Prozeßkammer 26 angeordnet sind.

Nähere Angaben zu einer auch im Rahmen der hier beschriebenen Vorrichtung einsetzbaren Prozeßkammer finden sich in den älteren deutschen Patentanmeldungen P 39 36 955.2 und P 40 32 328.5.

An die Prozeßkammer 26 schließt sich eine Belüftungskammer 32 an, die wiederum als Durchlaufkammer mit einem Einlaß und einem Auslaß ausgebildet ist. Der Einlaß der Belüftungskammer 32 ist verschließbar mittels der dritten Schleuse 23, die gleichzeitig zum Verschließen des Auslasses der Prozeßkammer 26 dient. Der Auslaß der Belüftungskammer 32 ist verschließbar mittels einer vierten Schleuse 34. Innerhalb der Belüftungskammer 32 ist die dritte Transporteinrichtung 12 angeordnet, die die Flachbaugruppen von der zweiten Transporteinrichtung 10 übernimmt und an die vierte Transporteinrichtung 14 weitergibt. Die Belüftungskammer 32 ist angeschlossen an eine weitere Vakuumpumpe 36, mit deren Hilfe der Innenraum der Belüftungskammer auf den Prozeßdruck der Prozeßkammer 26 evakuiert werden kann. Belüftet wird die Belüftungskammer 30 mit Hilfe von kohlenwasserstofffreier Luft definierter Feuchte unter Umgebungsdruck. Die Belüftungskammer 32 ist evakuiert, wenn die dritte Schleuse 28 geöffnet ist, damit die Flachbaugruppen 4 aus der Prozeßkammer 26 in die Belüftungskammer 32 überführt werden können. Zu diesem Zeitpunkt sind die beiden Schleusen 22 und 34 geschlossen. Die Belüftungskammer 32 steht unter Umgebungsdruck, wenn die vierte Schleuse 34 geöffnet ist, damit die Flachbaugruppen 4 aus der Belüftungskammer 32 in eine noch zu erläuternde Befeuchtungskammer 38 übergeben werden können. Zu diesem Zeitpunkt ist die Schleuse 28 geschlossen, damit in der Prozeßkammer 26 stets der Prozeßdruck gehalten werden kann.

An die Belüftungskammer 32 schließt sich unmittelbar die Befeuchtungskammer 38 an. Diese ist wiederum als Durchlaufkammer ausgebildet und weist einen Einlaß 40 sowie einen Auslaß 42 auf. Da der Innenraum der Befeuchtungskammer 38 im Betrieb stets unter Umgebungsdruck steht, sind der Einlaß 40 und der Auslaß 42 nicht verschließbar und stets offen. Innerhalb der Befeuchtungskammer 38 ist die vierte Transporteinrichtung 14 angeordnet, der die Flachbaugruppen 4 bei geöffneter vierter Schleuse 34 von der dritten Transporteinrichtung 12 übergeben werden. Die vierte Transporteinrichtung 14 übergibt die Flachbaugruppen 4 am Auslaß 42 zur fünften Transporteinrichtung 16. Innerhalb der Befeuchtungskammer 38 liegt eine Gasatmosphäre vor, die beim dargestellten Ausführungsbeispiel aus Luft mit einem Wassergehalt in gasförmiger Phase besteht. Der Befeuchtungskammer 38 zugeordnet sind nicht dargestellte Einrichtungen zur Klimatisierung der Luftatmosphäre innerhalb der Befeuchtungskammer 38, die für die gewünschten Zustandsbedingungen, insbesondere die gewünschte Temperatur sowie die gewünschte relative Feuchtigkeit sorgen. Die Temperatur liegt oberhalb der Umgebungstemperatur in einem Bereich von beispielsweise 40 bis 50° C. Um diese oberhalb der Umgebungstemperatur liegende Temperatur zu erhalten ist in der Befeuchtungskammer vorzugsweise eine nicht dargestellte Heizeinrichtung angeordnet, die zugleich für die Vorheizung der Flachbaugruppen zur Vorbereitung auf den nachfolgenden eigentlichen Lötprozeß dient.

Im Bereich des Einlasses 40 der Befeuchtungskammer 38 ist eine erste Düseneinrichtung 44 angeordnet. Eine zweite Düseneinrichtung 46 ist im Bereich des Auslasses 42 angeordnet. Durch diese beiden Düseneinrichtungen wird jeweils gereinigte Luft ausgeblasen, so daß am Einlaß und am Auslaß ein Luftschleier erzeugt wird. Dadurch wird einerseits die Gasatmosphäre innerhalb der Befeuchtungskammer 38 von der Umgebung getrennt. Andererseits kann durch geeignete Temperatursteuerung des mittels der Düseneinrichtung 46 erzeugten Luftschleiers dafür gesorgt werden, daß die Temperatur der Oxidschichten auf den Lötanschlußflächen der Flachbaugruppen 4 unter den Taupunkt sinkt, so daß die Kondensation des in den Fehlstellen der Oxidschichten adsorbierten Wassers dadurch unterstützt wird.

Alternativ zur vorstehend beschriebenen Ausbildung der Befeuchtungskammer 38 kann diese in zwei aufeinanderfolgende Kammerabschnitte unterteilt sein, wobei dann der dem Auslaß 42 nähere Kammerabschnitt auf einer im Vergleich zum ersten Kammerabschnitt niedrigeren Temperatur gehalten wird, um die vorstehend genannte Kondensation zu unterstützen.

Unmittelbar hinter der Befeuchtungskammer 38 in Durchlaufrichtung der Flachbaugruppen 4 ist ein Löteinrichtung 48 angeordnet, die beim dargestellten Ausführungsbeispiel als Wellenlöteinrichtung ausgebildet ist. Sie umfaßt einen Tiegel 50, in dem sich im Betrieb schmelzflüssiges Lot befindet. Ferner umfaßt sie zwei Schächte 52 und 54, die jeweils an ihrem oberen Ende eine quer zur Transportrichtung Y der Flachbaugruppen 4 verlaufende, schlitzförmige Austrittsöffnung aufweisen. Durch diese Schächte wird mittels einer nicht dargestellten Pumpeinrichtung flüssiges Lot nach oben gefördert, so, daß das durch die Austrittsöffnungen austretende Lot dort eine stehende Lotwelle (nicht dargestellt) bildet. Während eine Flachbaugruppe 4 über die Löteinrichtung 48 transportiert wird, berührt die Unterseite der jeweiligen Leiterplatte 6 die Kämme der Lotwellen, so daß die Unterseite der Leiterplatte mit Lot benetzt wird und die von der Unterseite vorstehenden SMD-Bauelemente sowie Anschlüsse von THM-Bauelementen in das Lot eintauchen. Das Lot benetzt die Fügeteiloberflächen bzw. Lötanschlußflächen und bildet die kohäsive Bindungscharakteristik.

Nicht dargestellt in Fig. 1 ist eine bei diesem Ausführungsbeispiel nicht vorgesehene Schutzgasaufblaseinrichtung, die der Löteinrichtung 48 folgen kann und mittels der die Lötstellen unmittelbar nach dem Lötprozeß mit einem Schutzgas, insbesondere Stickstoff, beaufschlagt werden.

Bei der vorstehend beschriebenen Vorrichtung gehören die Evakuierungskammer 18, die Prozeßkammer 26, die Belüftungskammer 32 und die Befeuchtungskammer 38 sämtlich zur Dekapierungseinrichtung, in der ein zweistufiger Dekapierungsprozeß durchgeführt wird. Eine Stufe dieses Dekapierungsprozesses ist durch die Plasma-Vorbehandlung in der Prozeßkammer 26 gebildet. Dabei werden anorganische und organische Passivschichten von den Oxidschichten auf den Lötanschlußflächen entfernt. Die andere Stufe dieses Dekapierungsprozesses wird eingeleitet in der Befeuchtungskammer 38, in der der gasförmige Hilfsstoff in Form von Wasser zunächst in den Fehlstellen der Oxidschichten zur Adsorption eingebracht wird und dann kondensiert wird. Abgeschlossen wird die Dekapierung jedoch erst in der Löteinrichtung 48 zu dem Zeitpunkt, zu dem die betrachtete Leiterplatte auf die in Durchlaufrichtung erste Lotwelle aufläuft. Erst zu diesem Zeitpunkt erfolgt die schlagartige Erwärmung der Oxidschicht mit dem eingelagerten Hilfsstoff, wodurch die Oxidschicht vom metallischen Untergrund der Lötanschlußfläche abgesprengt wird. Somit bildet die Löteinrichtung zugleich die Erwärmungseinrichtung der Dekapierungseinrichtung.

Daß die Löteinrichtung zugleich die Erwärmungseinrichtung der Dekapierungseinrichtung bildet, ist zwar vorteilhaft, jedoch nicht notwendig. Vielmehr könnte zwischen der Befeuchtungskammer 38 und der Löteinrichtung 48 eine zusätzliche, separate Erwärmungseinrichtung angeordnet sein.

Im folgenden wird das Verfahren zum Löten von elektronischen Flachbaugruppen mittels der vorstehend beschriebenen Vorrichtung ausführlicher erläutert.

Auf einem wellenlötgerechten Layout werden die steckbaren Bauelemente formschlüssig fixiert. Die SMD-Bauelemente werden mittels eines Klebers fixiert, und die gesamte Flachbaugruppe wird bei einer Temperatur T = 125° C für eine Dauer von t = 5 min. zur Kleberaushärtung getempert. Die auf diese Weise vorbereiteten Flachbaugruppen 6 werden während einer ersten Stufe des kombinierten Dekapierungsprozesses einer trockenchemischen Vorbehandlung unterzogen. Dabei handelt es sich bei dem hier beschriebenen bevorzugten Ausführungsbeispiel um eine Plasma-Vorbehandlung in einem Niederdruckplasma mit einem Prozeßdruck im Bereich von P = (10 bis 150) Pa, einer Plasma-Leistungsdichte J = (0,05 bis 1) W/cm², einem Prozeßgasvolumenstrom V = (0,1 bis 3) 1/Std., einer Prozeßtemperatur T = (20 bis 100)° C und einer Prozeß- bzw. Vorbehandlungsdauer t = (30 bis 600) s. Als Prozeßgase können z.B. O₂, N₂, H₂, CO₂ oder N₂O und geeignete Kombinationen dieser Gase sowie auch Luft zur Anwendung kommen. Dabei bestimmt die Art des Prozeßgases die Wahl der Plasmaparameter. Die Auswahl der Plasmaatmosphäre und -parameter richtet sich nach der Art und erwarteten Dicke der hauptsächlich organischen Kontaminationsschichten auf den Lötanschlußflächen und nach der fügetechnisch erforderlichen Aktivierung der Fügeteiloberflächen.

Erfolgreich angewendet wurde beispielsweise eine H₂-Plasmaatmosphäre mit dem Prozeßdruck P = 40 Pa, dem Prozeßgasvolumenstrom V = 1,5 1/Std., der Plasmaleistungsdichte J = 0,7 W/cm² und der Vorbehandlungsdauer t = 480 s. Ferner wurde erfolgreich angewendet ein Luftplasma mit dem Prozeßdruck P = 40 Pa, dem Prozeßgasvolumenstrom V = 1,5 1/Std., der Plasmaleistungsdichte J = 0,1 W/cm² und der Vorbehandlungsdauer t = 240 s.

Die Plasma-Vorbehandlung sichert prozeßabgestuft die homogene Beseitigung der organischen Passiv- bzw. Kontaminationsschichten auf den Lötanschlußflächen und die zur Gewährleistung einer hohen Lotausbreitung und Benetzung notwendige Aktivierung der Oberflächen der Oxidschichten auf den Lötanschlußflächen.

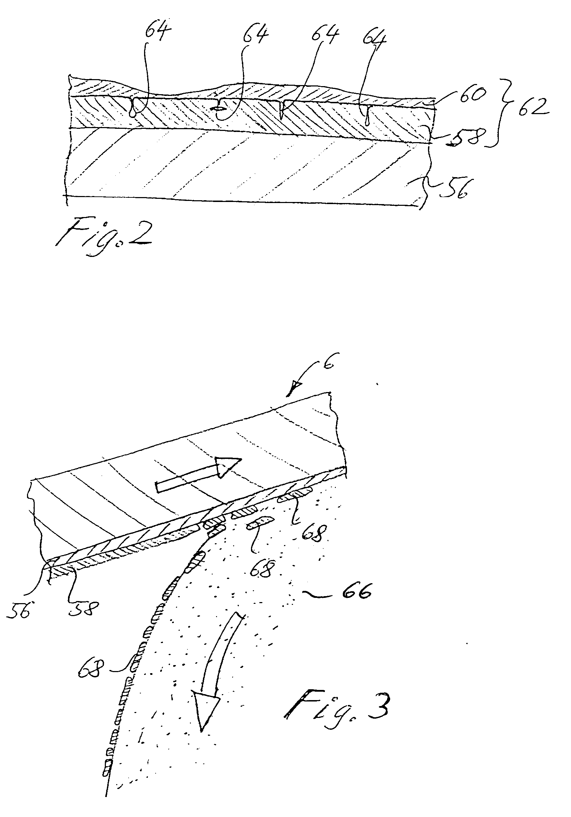

Fig. 2 zeigt schematisch im Schnitt ausschnittsweise eine Lötanschlußfläche. Diese weist einen Schichtaufbau auf, deren metallischer Grundwerkstoff 56 beispielsweise aus Sn, SnPb, AgPd oder AgPdBi besteht. Vor der Dekapierung haftet am metallischen Grundwerkstoff 56 eine Oxidschicht 58, die aus Oxiden der Metalle des Untergrundes 56 besteht. Auf der Oxidschicht 58 haftet eine überwiegend organische Kontaminationsschicht 60. Die Oxidschicht 58 und die Kontaminationsschicht 60 bilden zusammen die Passivschichten 62, die durch die Dekapierung entfernt werden.

Die in der Prozeßkammer 26 durch die Plasma-Vorbehandlung von den organischen Kontaminationsschichten 60 befreiten Lötanschlußflächen und somit die gesamte Flachbaugruppe 4 wird nachfolgend in der Belüftungskammer 32 mit einer kohlenwasserstofffreien Gasatmosphäre zwangsbelüftet. Bei dieser kohlenwasserstofffreien Gasatmosphäre kann es sich um kohlenwasserstofffreie Luft handeln. Eine Belüftung mit Stickstoff (N₂) hat sich ebenfalls als geeignet erwiesen. Durch die Belüftung in der Belüftungskammer 32 soll der erneuten Entstehung organischer Kontaminationen vorgebeugt werden. Dieses Ziel kann unter geeigneten Umständen auch erreicht werden, wenn die Belüftung mit Umgebungsluft erfolgt, wobei allerdings die Flachbaugruppen der Umgebungsluft für nur verhältnismäßig kurze Zeit von beispielsweise 30 bis 600 s ausgesetzt sein sollten.

Die durch die Plasma-Vorbehandlung freigelegte und aktivierte Oxidschicht 58, die beispielsweise aus SnPb-Mischoxid besteht, auf den Lötanschlußflächen wird nachfolgend der zweiten Stufe des kombinierten Dekapierungsprozesses zugeführt.

Durch die Plasma-Vorbehandlung ist die natürliche Topologie der Oxidschicht 58 freigelegt worden. Diese Oxidschicht 58 weist eine Häufung von Fehlstellen 64 auf, deren Häufigkeit u.a. mit der Schichtdicke zunimmt. Die Gesamtoberfläche dieser dreidimensionalen Schichtfehler bzw. Fehlstellen ist vielfach größer als die Fläche der Projektion der betrachteten Lötanschlußfläche. Durch die Plasma-Vorbehandlung werden Valenzbindungen aufgebrochen, die durch die abgetragene organische Kontaminationsschicht 60 abgesättigt waren. Diese aufgebrochenen Valenzbindungen kennzeichnen die Reaktivität der freigelegten Oxidschicht. Wenn die vorbehandelten Lötanschlußflächen, die eine thermodynamisch instabile Oxidschichttopologie aufweisen, einer Atmosphäre ausgesetzt werden, die einen gasförmigen, kondensationsfähigen Hilfsstoff enthält, so werden entsprechend der Häufigkeit der dreidimensionalen Schichtfehler homogen verteilte Kondensationsvorgänge stattfinden. Durch die Plasma-Vorbehandlung ist ein hydrophiler Charakter der Metalloxide provoziert worden. Die hydrophilen Metalloxide werden daher in einer geeigneten Atmosphäre der vorstehend genannten Art oberflächenhaft durch Kondensation des Hilfsstoffes gesättigt.

Der vorstehend beschriebene Vorgang, bei dem zunächst der gasförmige Hilfsstoff in den Fehlstellen adsorbiert wird und dann kondensiert wird, kann als Befeuchtung bezeichnet werden und läuft in der Befeuchtungskammer 38 ab, in der eine Gasatmosphäre aus Luft mit einem Gehalt an Wasser als Hilfsstoff vorhanden ist, wobei die relative Luftfeuchtigkeit zumindest 30 % beträgt. Zwar würde eine Adsorption von Luftfeuchte auch spontan erfolgen. Zur Steigerung des Volumens des expansionsfähigen Hilfsstoffes wird die Befeuchtung jedoch vorzugsweise in der beschriebenen Befeuchtungskammer 38 durchgeführt, die verfahrenstechnisch eine Kondensationsstrecke darstellt. Die Temperatur des Wasserdampfes in der Befeuchtungskammer 38 beträgt bei Normaldruck 40 bis 85° C, vorzugsweise 75 bis 85° C. Die Verweilzeit in der Befeuchtungskammer beträgt beispielsweise 1 bis 30 s und liegt vorzugsweise näher am oberen Ende des genannten Bereiches. Bei dem beschriebenen Ausführungsbeispiel dient die Kondensationsstrecke zugleich als Vorheizzone für die Flachbaugruppen 6, damit die Flachbaugruppen dem nachfolgenden Lötprozeß auch temepraturmäßig aufbereitet zur Verfügung gestellt werden. Dabei muß allerdings darauf geachtet werden, daß die Kondensationstemperatur des verwendeten Hilfsstoffes oberhalb der Vorheiztemperatur liegt. Unterstützt wird die Kondensation des Hilfsstoffes in den Fehlstellen 64 durch den am Auslaß der Befeuchtungskammer 38 mittels der Düseneinrichtung 46 erzeugten Luftschleier.

Der Befeuchtungskammer 38 folgt unmittelbar die als Wellenlöteinrichtung ausgebildete Löteinrichtung 48, der die in beschriebener Weise vorbehandelten Flachbaugruppen 4 zugeführt werden. Dabei sind kürzeste Wegstrecken zwischen der Befeuchtungskammer 48 und der mittels des ersten Schachtes 52 erzeugten Lotwelle zweckmäßig, um Adsorptions- und damit Dekapierungsverlusten vorzubeugen. Die auf vorstehend beschriebene Weise behandelten Flachbaugruppen 4 werden somit unmittelbar nach der Kondensationsstrecke der (nicht dargestellten) ersten Lotwelle zugeführt. Die Lottemperatur beträgt dabei beispielsweise 245° C, und als mittlere Lötzeit sind beispielsweise 5 s vorgesehen.

In Fig. 3 ist schematisch und vergrößert der Zustand dargestellt, der sich beim Auflaufen der bestückten und vorbehandelten Leiterplatte 6 auf die Lotwelle 66 ergibt, die in der Löteinrichtung 48 mittels des Schachtes 52 erzeugt wird. Die Lotwelle fließt nach links in Fig. 1 ab, d.h. in Richtung des in die Lotwelle 66 in Fig. 3 eingezeichneten Pfeils. Die Leiterplatte 6 läuft von links nach rechts in den Fig. 1 und 3 auf die Lotwelle 66 auf, d.h. in Richtung des in die Leiterplatte 6 in Fig. 3 eingezeichneten Pfeils. An der Unterseite der Leiterplatte haftet der metallische Untergrund 56 der Lötanschlußfläche. Auf diesem Untergrund 56 haftet die Oxidschicht 58 mit endlich vielen, definiert gesättigten Oxiden, bei denen es sich beispielsweise um Sn-, Pb- und/oder SnPb-Mischoxide handelt. Im Übergangsbereich zwischen der Oxidschicht 58 und der Lotwelle 66 liegt zum Zeitpunkt des ersten Kontaktes zwischen diesen ein verhältnismäßig großer zeitlicher Temperaturgradient T/ t vor, der zumindest einen Wert von 50 K/s, vorzugsweise von mehr als 150 K/s haben sollte und im Mikrobereich vermutlich noch wesentlich höhere Werte erreicht. Die dem zeitlichen Temperaturgradienten entsprechend schnelle Erwärmung der Oxidschicht 58 führt zu einer spontanen Verdampfung, d.h. Volumenexpansion des in den Fehlstellen 64 eingelagerten, kondensierten Hilfsstoffes im ortho-gonalen und horizontalen Oxidschichtfehlerbereich. Das Hilfsstoffvolumen nimmt beispielsweise im Falle von Wasser (H₂O) um den Faktor 1000 zu. Dabei bestimmt der auftretende zeitliche Temperaturgradient die Expansionsgeschwindigkeit des adsorbierten und kondensierten Hilfsstoffes. Diese spontane Volumenexpansion bewirkt ein mikro-explosionsartiges Absprengen der Oxidschicht 58 vom metallischen Grundwerkstoff 56, also beispielsweise der die Lötanschlußfläche bildenden SnPb-Schicht. Diese zweite und abschließende Stufe des Dekapierungsprozesses findet unmittelbar bei dem linienhaften Eintritt der Unterseite der bestückten Leiterplatte 6 in die Lotwelle 66 statt, so daß die Erzeugung virginer Lötanschlußflächen etwa zeitgleich mit der Benetzung dieser Lötanschlußflächen durch das flüssige Lot verläuft und somit keine benetzungshemmenden Passivschichten die reproduzierbare Ausbildung der Lötstellen zwischen den (in Fig. 3 nicht dargestellten) SMD-Bauelementen und/oder THM-Bauelementen einerseits und dem Pad bzw. der Durchkontaktierung auf der Leiterplatte 6 andererseits behindert. Dieser Vorgang ist in Fig. 3 schematisch dargestellt. Die Mikroexplosionen zerlegen die Oxidschicht 58 in Oxid-Bruchstücke 68, die zugleich durch die Mikroexplosionen vom metallischen Untergrund 56 abgeschert oder abgehoben werden. Die abgesprengten Oxid-Bruchstücke 68 verlassen mit der ablaufenden Lotwelle 66 die Lot-Verbindungsebene, wie dies durch die auf der linken Flanke der Lotwelle 66 in Fig. 3 gezeigten, abschwimmenden Oxid-Bruchstücke 68 erläutert ist. Auf gleiche Weise, wie dies vorstehend für eine Lötanschlußflache der Leiterplatte 6 erläutert ist, werden die Oxidschichten von den Lötanschlußflächen der Bauelemente abgesprengt.

Die die zweite, mittels des Schachtes 54 erzeugte Lotwelle verlassenden, frischen Lötstellen werden vorzugsweise einer Schutzgasatmosphäre ausgesetzt, mit deren Hilfe die Lötstellentopologie in günstiger Weise modifiziert werden kann. Bei diesem Schutzgas handelt es sich beispielsweise um Stickstoff (N₂).

Die Wirkung des vorstehend beschriebenen Dekapierungsprozesses kann in ihrer Quantität über das Volumen des adsorbierten Hilfsstoffes und das Temperaturprofil der Löteinrichtung 48, insbesondere den Temperaturgradienten T/ t, beeinflußt werden.

Bei dem erfindungsgemäßen Verfahren zum Löten von elektronischen Flachbaugruppen, insbesondere mit Bauelementen bestückten Leiterplatten, wird während des Dekapierungsprozesses zunächst in Fehlstellen der Oxidschichten auf den Lötanschlußflächen ein kondensationsfähiger Hilfsstoff, beispielsweise Wasser, zur Adsorption gebracht und in den Fehlstellen zumindest teilweise kondensiert. Danach werden die Oxidschichten einer derart schnellen Erwärmung ausgesetzt, daß der in den Fehlstellen kondensierte Hilfsstoff explosionsartig verdampft und dadurch die Oxidschicht aufbricht und vom metallischen Grundwerkstoff absprengt, so daß die Lötanschlußflächen für den nachfolgenden eigentlichen Lötprozeß in virginen Zustand gebracht sind. Die schnelle Erwärmung erfolgt im Falle des Wellenlötens vorzugsweise durch die Lotwelle selber. Sofern auch nicht-oxidische Passivschichten dekapiert werden müssen, erfolgt dies vorzugsweise in einer vorangehenden Stufe des Dekapierungsprozesses, während der die Oxidschicht hydrophiliert wird. Hierzu eignet sich eine Plasma-Vorbehandlung. Die erfindungsgemäße Vorrichtung weist eine Befeuchtungskammer auf, in der der kondensationsfähige Hilfsstoff den hydrophilen Oxidschichten angeboten und von diesen adsorbiert wird.

## Patentansprüche

1. Verfahren zum Löten von elektronischen Flachbaugruppen, insbesondere mit Bauelementen bestückten Leiterplatten, wobei zunächst während eines Dekapierungsprozesses auf den Lötanschlußflächen vorhandene Oxidschichten weitgehend entfernt werden und danach während eines Lötprozesses die metallischen Lötanschlußflächen mit flüssigem Lot benetzt werden, dadurch gekennzeichnet, daß während des Dekapierungsprozesses zunächst in Fehlstellen der Oxidschichten ein kondensationsfähiger Hilfsstoff zur Adsorption gebracht und in den Fehlstellen zumindest teilweise kondensiert wird und danach die Oxidschichten einer derart schnellen Erwärmung ausgesetzt werden, daß der in den Fehlstellen kondensierte Hilfsstoff explosionsartig verdampft und dadurch die Oxidschicht aufbricht und vom metallischen Untergrund absprengt.

2. Verfahren nach Anspruch 1, dadurch gekennzeichnet, daß der Hilfsstoff Wasser ist.

3. Verfahren nach Anspruch 1, dadurch gekennzeichnet, daß der Hilfsstoff aus der Gruppe Methanol, Aceton und Äthanol gewählt ist.

4. Verfahren nach einem der Ansprüche 1 bis 3, dadurch gekennzeichnet, daß jeweils die gesamte Flachbaugruppe einer den Hilfsstoff in gasförmiger Phase enthaltenden Gasatmosphäre ausgesetzt wird.

5. Verfahren nach Anspruch 4 in Verbindung mit Anspruch 2, dadurch gekennzeichnet, daß die Gasatmosphäre Luft mit einem definierten Gehalt an Wasser als Hilfsstoff ist.

6. Verfahren nach einem der Ansprüche 1 bis 5, dadurch gekennzeichnet, daß der zeitliche Temperaturgradient in der Oxidschicht mit dem adsorbierten Hilfsstoff während der Erwärmung derselben einen Wert von mehr als 50 K/s erreicht.

7. Verfahren nach Anspruch 6, dadurch gekennzeichnet, daß der zeitliche Temperaturgradient einen Wert von mehr als 150 K/s erreicht.

8. Verfahren nach einem der Ansprüche 1 bis 7, dadurch gekennzeichnet, daß die Erwärmung der Oxidschicht mit dem adsorbierten Hilfsstoff zeitlich vor dem Lötprozeß getrennt von diesem erfolgt.

9. Verfahren nach einem der Ansprüche 1 bis 7, dadurch gekennzeichnet, daß die Erwärmung der Oxidschicht mit dem adsorbierten Hilfsstoff während des Lötprozesses durch über das Lot zugeführte Wärmeenergie erfolgt.

10. Verfahren nach Anspruch 9, wobei während des Lötprozesses die einzelne Flachbaugruppe über zumindest eine stehende Lotwelle transportiert wird und dabei der Kamm der Lotwelle die Baugruppenunterseite berührt, dadurch gekennzeichnet, daß die Erwärmung der Oxidschicht mit dem adsorbierten Hilfsstoff zum Zweck des Absprengens der Oxidschicht unmittelbar durch die Lotwelle erfolgt.

11. Verfahren nach einem der Ansprüche 1 bis 10, dadurch gekennzeichnet, daß während des Dekapierungsprozesses vor der Adsorption des Hilfsstoffs eine Vorbehandlung zur Beseitigung von Passivschichten auf den Oxidschichten durchgeführt wird.

12. Verfahren nach Anspruch 11, dadurch gekennzeichnet, daß die Vorbehandlung naßchemisch mit Hilfe eines Reinigungsmittels erfolgt.

13. Verfahren nach Anspruch 11, dadurch gekennzeichnet, daß die Vorbehandlung mit Hilfe eines Plasmas erfolgt, dem die Lötanschlußflächen ausgesetzt werden.

14. Verfahren nach Anspruch 13, dadurch gekennzeichnet, daß das Prozeßgas des Plasmas aus O₂, N₂, H₂, CO₂, N₂O oder H₂O oder einer Kombination dieser Gase besteht.

15. Verfahren nach Anspruch 14, dadurch gekennzeichnet, daß das Prozeßgas Luft ist.

16. Verfahren nach einem der Ansprüche 13 bis 15, dadurch gekennzeichnet, daß die Plasmavorbehandlung erfolgt in einem Niederdruckplasma mit einem Prozeßdruck P = (10 bis 150) Pa, einer Plasmaleistungsdichte J = (0,05 bis 1) W/cm², einem Prozeßgasvolumenstrom V = (0,1 bis 3) Liter/h, einer Prozeßtemperatur T = (20 bis 100)° C und einer Vorbehandlungsdauer t = (30 bis 600) s.

17. Verfahren nach einem der Ansprüche 13 bis 16, dadurch gekennzeichnet, daß zwischen der Plasma-Vorbehandlung und der adsorptiven Einlagerung des Hilfsstoffes eine Belüftung der Flachbaugruppe in kohlenwasserstofffreier Luft definierter Feuchte erfolgt.

18. Verfahren nach einem der Ansprüche 1 bis 17, dadurch gekennzeichnet, daß unmittelbar nach dem Lötprozeß die Lötstellen einer Schutzgasatmoshäre ausgesetzt werden.

19. Verfahren nach Anspruch 18, dadurch gekennzeichnet, daß Hauptbestandteil des Schutzgases Stickstoff ist.

20. Vorrichtung zum Löten von elektronischen Flachbaugruppen, insbesondere mit Bauelementen bestückten Leiterplatten, zur Durchführung des Verfahrens nach einem der Ansprüche 1 bis 19, mit einer Dekapierungseinrichtung, mittels derer auf den Lötanschlußflächen vorhandene Oxidschichten weitgehend entfernt werden, und mit einer Löteinrichtung, mittels derer die Lötanschlußflächen mit flüssigem Lot benetzt werden, wobei die einzelne Flachbaugruppe zunächst in der Dekapierungseinrichtung und danach in der Löteinrichtung behandelt wird, dadurch gekennzeichnet, daß die Dekapierungseinrichtung eine Befeuchtungskammer (38) aufweist, in der die Flachbaugruppe (4) während einer einstellbaren Behandlungsdauer verweilt und in der eine Gasatmosphäre vorhanden ist, die einen gasförmigen, kondensationsfähigen Hilfsstoff enthält, wobei die Zustandsbedingungen (Druck, Temperatur, relative Hilfsstoffkonzentration) der Gasatmosphäre derart einstellbar sind, daß der Hilfsstoff in den Oxidschichten (58) adsorbiert wird und zumindest teilweise kondensiert, und daß eine Erwärmungseinrichtung (48) vorgesehen ist, mittels derer im Anschluß an die Kondensation des Hilfsstoffes die Oxidschichten schnell erwärmt werden.

21. Vorrichtung nach Anspruch 20, dadurch gekennzeichnet, daß die Befeuchtungskammer (38) mittels kohlenwasserstofffreier Luft belüftbar ist.

22. Vorrichtung nach Anspruch 20, dadurch gekennzeichnet, daß die Befeuchtungskammer (38) als Durchlaufkammer mit einem Einlaß (40) und einem Auslaß (42) ausgebildet ist, durch die die Flachbaugruppen (4) mit Hilfe einer Transporteinrichtung (14, 16) transportiert werden.

23. Vorrichtung nach Anspruch 22, gekennzeichnet durch eine nahe dem Einlaß (40) und eine nahe dem Auslaß (42) der Durchlaufkammer angeordnete Düseneinrichtung (44 bzs. 46), wobei durch die beiden Düseneinrichtungen jeweils Luft ausgeblasen wird und dadurch am Einlaß und am Auslaß ein Luftschleier erzeugt wird.

24. Vorrichtung nach einem der Ansprüche 20 bis 23, dadurch gekennzeichnet, daß die Erwärmungseinrichtung durch die Löteinrichtung (48) gebildet ist.

25. Vorrichtung nach Anspruch 24 in Verbindung mit Anspruch 22 oder 23, dadurch gekennzeichnet, daß die Löteinrichtung (48) nahe dem Auslaß (42) der Durchlaufkammer angeordnet ist und daß die Transporteinrichtung (14, 16) die Flachbaugruppen (4) aus der Durchlaufkammer heraus und durch die Löteinrichtung transportiert.

26. Vorrichtung nach Anspruch 24 oder 25, dadurch gekennzeichnet, daß die Löteinrichtung (48) eine Wellenlöteinrichtung ist, die zumindest eine stehende Lotwelle erzeugt, mit der die Lötanschlußflächen in Berührung gebracht werden.

27. Vorrichtung nach Anspruch 26, dadurch gekennzeichnet, daß der Löteinrichtung (48) eine schutzgasaufblaseinrichtung zugeordnet ist, mittels der die Lötstellen unmittelbar nach dem Lötprozeß mit einem Schutzgas, insbesondere Stickstoff, beaufschlagt werden.

28. Vorrichtung nach Anspruch 24 oder 25, dadurch gekennzeichnet, daß die Löteinrichtung eine ReflowLöteinrichtung ist.

29. Vorrichtung nach einem der Ansprüche 20 bis 28, dadurch gekennzeichnet, daß die Befeuchtungskammer (38) zugleich als Prozeßkammer für eine Plasma-Vorbehandlung der Lötanschlußflächen dient und daß in der Befeuchtungskammer (38) wahlweise die Gasatmosphäre oder eine Prozeßgas-Atmosphäre für die Plasma-Vorbehandlung herstellbar ist.

30. Vorrichtung nach einem der Ansprüche 20 bis 28, dadurch gekennzeichnet, daß die Dekapierungseinrichtung zusätzlich zu der Befeuchtungskammer (38) eine Prozeßkammer (26) zur Plasma-Vorbehandlung der Lötanschlußflächen aufweist.

31. Vorrichtung nach Anspruch 30, dadurch gekennzeichnet, daß die Prozeßkammer (26) eine Niederdruck-Prozeßkammer ist.

32. Vorrichtung nach Anspruch 30 oder 31, dadurch gekennzeichnet, daß die Prozeßkammer (26) als Durchlaufkammer mit einem Einlaß und einem Auslaß ausgebildet ist, durch die die Flachbaugruppen (4) mit Hilfe einer Transporteinrichtung (10) transportiert werden.

33. Vorrichtung nach Anspruch 32 in Verbindung mit Anspruch 22 oder 23, dadurch gekennzeichnet, daß zwischen der Prozeßkammer (26) und der Befeuchtungskammer (38) eine Belüftungskammer (32) angeordnet ist, in der eine Belüftung der Plasmavorbehandelten Flachbaugruppen (4) mit kohlenwasserstofffreier Luft erfolgt, wobei die Prozeßkammer (26), die Belüftungskammer (32) und die Befeuchtungskammer (38) in dieser Reihenfolge unmittelbar aufeinander folgen und die Innenräume dieser drei Kammern jeweils durch eine Schleuse (22, 28, 34) voneinander trennbar sind.

## Claims

1. A process for soldering electronic boards, in particular, printed circuit boards with devices installed on them, whereby first during a pickling process, oxide layers present on the soldering connection surfaces are largely removed and then during a soldering process, the metal soldering connection surfaces are wetted with molten solder, characterized in that during the pickling process first a condensable process material is introduced for absorption into flaws in the oxide layers and at least partially condensed in the flaws, and then the oxide layers are exposed to rapid heating such that the process material condensed in the flaws vaporizes explosively and thus the oxide layer breaks up and cracks off the metal basis material.

2. The process according to Claim 1, characterized in that the process material is water.

3. The process according to Claim 1, characterized in that the process material is selected from the group methanol, acetone, and ethanol.

4. The process according to one of Claims 1 through 3, characterized in that in each case the entire board is exposed to a gas atmosphere containing the process material in gaseous phase.

5. The process according to Claim 4 in conjunction with Claim 2, characterized in that the gas atmosphere is air with a specific water content as the process material.

6. The process according to one of Claims 1 through 5, characterized in that the temporal temperature gradient in the oxide layer with the absorbed process material reaches a value of more than 50 K/s during its heating.

7. The process according to Claim 6, characterized in that the temporal temperature gradient reaches a value of more than 150 K/s.

8. The process according to one of Claims 1 through 7, characterized in that heating of the oxide layer with the absorbed with the absorbed process material occurs separately in time before the soldering process.

9. The process according to one of Claims 1 through 7, characterized in that the heating of the oxide layer with the absorbed process material occurs during the soldering process by means of heat energy delivered by the solder.

10. The process according to Claim 9, whereby during the soldering process the individual boards are transported over at least one standing wave of solder and at this time the crest of the wave of solder comes into contact with the bottom side of the board, characterized in that the heating of the oxide layer with the absorbed process material for the purpose of cracking off the oxide layer occurs directly by means of the wave of solder.

11. The process according to one of Claims 1 through 10, characterized in that during the pickling process a pretreatment for removal of passive layers on the oxide layers is performed before the absorption of the process material.

12. The process according to Claim 11, characterized in that the pretreatment occurs wet chemically with the help of a cleansing agent.

13. The process according to Claim 11, characterized in that the pretreatment occurs with the help of a plasma to which the soldering connection surfaces are exposed.

14. The process according to Claim 13, characterized in that the process gas of the plasma consists of O₂, N₂, H₂, CO₂, N₂O, or H₂O, or a combination of these gases.

15. The process according to Claim 14, characterized in that the process gas is air.

16. The process according to one of Claims 13 through 15, characterized in that the plasma pretreatment occurs in a low-pressure plasma with a process pressure P = (10 to 150) Pa, a plasma output J = (0.5 to 1) W/cm², a process gas volume flow V = (0.1 to 3) liter/hr, a process temperature T = (20 to 100)°C, and a pretreatment period t = (30 to 600) sec.

17. The process according to one of Claims 13 through 16, characterized in that aeration of the board in hydrocarbon-free air with a specific humidity occurs between the plasma pretreatment and the absorptive infiltration of the process material.

18. The process according to one of Claims 1 through 17, characterized in that immediately after the soldering process the solder points are exposed to a protective gas atmosphere.

19. The process according to Claim 18, characterized in that the primary component of the protective gas is nitrogen.

20. A device for soldering electronic boards, in particular, printed circuit boards with devices installed on them, through the performance of the process according to one of Claims 1 through 19, with a pickling system, by means of which oxide layers present on the soldering connection surfaces are largely removed, and with a soldering system, by means of which the soldering connection surfaces are wetted with molten solder, whereby the individual boards are first processed in the pickling system and then in the soldering system, characterized in that the pickling system has a moisturizing chamber (38), in which the board (4) remains during an adjustable processing period and in which a gas atmosphere is present, which contains a gaseous, condensable process material, whereby the conditions (pressure, temperature, relative concentration of process material) of the gas atmosphere are adjustable such that the process material is absorbed in the oxide layers (58) and at least partially condensed, and that a heater (48) is provided, by means of which the oxide layers are rapidly heated following the condensation of the process material.

21. The device according to Claim 20, characterized in that the moisturizing chamber (38) can be aerated by means of hydrocarbon-free air.

22. The device according to Claim 20, characterized in that the moisturizing chamber (38) is designed as a pass-through chamber with an intake (40) and an outlet (42) through which the boards (4) are transported with the help of a conveyor device (14, 16).

23. The device according to Claim 22, characterized by a nozzle device (46) near the intake (40) and a nozzle device (46) near the outlet (42) of the pass-through chamber, whereby air is blown out by each of the two nozzle devices and an air curtain is generated at the intake and at the outlet.

24. The device according to one of Claims 20 through 23, characterized in that the heating device is formed by the soldering system (48).

25. The device according to Claim 24 in conjunction with Claim 22 or 23, characterized in that the soldering system (48) is disposed near the outlet (42) of the pass-through chamber and that the conveyor device (14, 16) transports the boards (4) out of the pass-through chamber and through the soldering system.

26. The device according to Claim 24 or 25, characterized in that the soldering system (48) is a wave soldering system which generates at least one standing wave of solder with which the soldering connection surfaces are brought into contact.

27. The device according to Claim 26, characterized in that a protective gas blowing device is provided in the soldering system (48), by means of which [blowing device] the solder points are bombarded with a protective gas, in particular, nitrogen, immediately after the soldering process.

28. The device according to Claim 24 or 25, characterized in that the soldering system is a reflow soldering system.

29. The device according to one of Claims 20 through 28, characterized in that the moisturizing chamber (38) also serves as a process chamber for plasma pretreatment of the soldering connection surfaces and that in the moisturizing chamber (38) the gas atmosphere or a process gas atmosphere can be selectively produced.

30. The device according to one of Claims 20 through 28, characterized in that the pickling system has a process chamber (26) for the plasma pretreatment of the soldering connection surfaces in addition to the moisturizing chamber (38).

31. The device according to Claim 30, characterized in that the process chamber (26) is a low-pressure process chamber.

32. The device according to Claim 30 or 31, characterized in that the process chamber (26) is designed as a pass-through chamber with an intake and an outlet, through which the boards (4) are transported with the help of a conveyor device (10).

33. The device according to Claim 32 in conjunction with Claim 22 or 23, characterized in that an aeration chamber (32) is disposed between the process chamber (26) and the moisturizing chamber (38), in which [aeration chamber] aeration of the plasma pretreated boards (4) with hydrocarbon-free air occurs, whereby the process chamber (26), the aeration chamber (32), and the moisturizing chamber (38) follow one another immediately in this order and the interiors of these three chambers can be separated respectively from each other by a lock (22, 28, 34).

## Revendications

1. Procédé de brasage d'éléments de surface, en particulier de carte à circuits imprimés équipés de composants, où d'abord, pendant un processus de décapage, on élimine largement les couches d'oxyde existant à la surface prévue pour le raccordement par brasage et, ensuite, pendant un processus de brasage, on mouille les surfaces métalliques prévues pour le raccordement par brasage, avec une brasure liquide, caractérisé en ce que, pendant le processus de décapage, on applique d'abord, en des endroits où il y a absence de couches d'oxyde, un produit auxiliaire susceptible de se condenser pour produire une adsorption et une condensation au moins partielle étant opérée aux endroits constituant des lacunes, les couches d'oxyde étant ensuite exposées à un chauffage rapide, de manière que le produit auxiliaire s'étant condensé aux endroits des lacunes se vaporise avec un effet d'explosion en faisant, de ce fait, éclater la couche d'oxyde et en l'éjectant du fond métallique sous-jacent.

2. Procédé selon la revendication 1, caractérisé en ce que le produit auxiliaire est de l'eau.

3. Procédé selon la revendication 1, caractérisé en ce que le produit auxiliaire est choisi dans le groupe formé par le méthanol, l'acétone et l'éthanol.

4. Procédé selon l'une des revendications 1 à 3, caractérisé en ce que l'on expose chaque fois l'ensemble de l'élément de surface à une atmosphère gazeuse contenant le produit auxiliaire sous forme gazeuse.

5. Procédé selon la revendication 4, en liaison avec la revendication 2, caractérisé en ce que l'atmosphère gazeuse est de l'air avec une teneur définie en eau, à titre d'élément auxiliaire.

6. Procédé selon l'une des revendications 1 à 5, caractérisé en ce que le gradient de temperature temporel dans la couche d'oxyde comportant le produit auxiliaire intégré par adsorption, pendant son chauffage, atteint une valeur supérieure à 50°K/s.

7. Procédé selon la revendication 6, caractérisé en ce que le gradient de température temporel atteint une valeur supérieure à 150°K/s.

8. Procédé selon l'une des revendications 1 à 7, caractérisé en ce que le chauffage de la couche d'oxyde, avec le produit auxiliaire adsorbé, s'effectue dans le temps avant le processus de brasage et séparément de celui ci.

9. Procédé selon l'une des revendication 1 à 7, caractérisé en ce que le chauffage de la couche d'oxyde, avec la substance auxiliaire adsorbée, pendant le processus de brasage, s'effectue au moyen d'une énergie calorifique apportée par la brasure.

10. Procédé selon la revendication 9, où, pendant le processus de brasage, l'élément de surface individuel est transporté en passant sur au moins une vague stationnaire de brasure et le peigne de vague de brasure entre en contact avec la face inférieure de ces éléments, caractérisé en ce que le chauffage de la couche d'oxyde, avec la substance auxiliaire adsorbée, en vue de l'éclatement de la couche d'oxyde, est effectué directement, au moyen de la vague de brasure.

11. Procédé selon l'une des revendications 1 à 10, caractérisé en ce que pendant le processus de décapage, avant l'adsorption de la substance auxiliaire, est effectué un prétraitement destiné à éliminer les couches passives situées sur les couches d'oxyde.

12. Procédé selon la revendication 11, caractérisé en ce que le prétraitement s'effectue par voie chimique humide à l'aide d'un produit de nettoyage.

13. Procédé selon la revendication 11, caractérisé en ce que le prétraitement s'effectue à l'aide d'un plasma, auquel l'on expose les faces de raccordement par brasage.

14. Procédé selon la revendication 13, caractérisé en ce que le gaz de processus du plasma est composé de O₂, N₂, H₂, CO₂, N₂O ou H₂O ou une combinaison de ces gaz.

15. Procédé selon la revendication 14, caractérisé en ce que le gaz de processus est de l'air.

16. Procédé selon l'une des revendications 13 à 15, caractérisé en ce que le prétraitement par plasma s'effectue dans un plasma basse pression, avec une pression de processus P égale = (10 à 150) Pa, une densité de puissance de plasma J = (0,05 à 1) W/cm², un courant volumétrique de gaz plasma V = (0,1 à 3) litres/heure, une température de processus T = (20 à 100)°C et une durée de prétraitement t = (30 à 600) s.

17. Procédé selon l'une des revendications 13 à 16, caractérisé en ce qu'entre le prétraitement par plasma et l'insertion par adsorption de la substance auxiliaire s'effectue une aération des éléments de surface, dans un air exempt d'hydrocarbure et ayant une humidité définie.

18. Procédé selon l'une des revendications 1 à 17, caractérisé en ce que les points de brasage sont exposés à une atmosphère protectrice immédiatement après le processus de brasage.

19. Procédé selon la revendication 18, caractérisé en ce que le composant principal du gaz protecteur est l'azote.

20. Dispositif de brasage d'éléments de surface électroniques, en particulier de cartes à circuits imprimées équipées de composants, pour mettre en oeuvre le procédé selon l'une des revendications 1 à 19, avec un dispositif de décapage, au moyen duquel on élimine notablement les couches d'oxyde existant sur les surfaces destinées au raccordement par brasage, et avec un dispositif de brasage, au moyen duquel on mouille avec une brasure liquide les surfaces destinées au raccordement par brasage, l'élément de surface individuel étant d'abord traité dans le dispositif de décapage et, ensuite, dans le dispositif de brasage, caractérisé en ce que le dispositif de décapage présente une chambre d'humidification (38), dans laquelle l'élément de surface (4) séjourne, pendant un temps de traitement réglable, et dans laquelle il y a une atmosphère de gaz contenant une substance auxiliaire condensable, se présentant sous forme gazeuse, les conditions d'état (pression, température, concentration relative du produit auxiliaire) de l'atmosphère gazeuse étant réglables, de manière que la substance gazeuse soit adsorbée dans les couches d'oxyde (58) et au moins partiellement condensée, et en ce qu'un dispositif de chauffage (48) est prévu, au moyen duquel les couches d'oxyde sont chauffées rapidement, après condensation de la substance auxiliaire.

21. Dispositif selon la revendication 20, caractérisé en ce que la chambre d'humidification (38) peut être aérée au moyen d'un air exempt d'hydrocarbure.

22. Dispositif selon la revendication 20, caractérisé en ce que la chambre d'humidification (38) est réalisée sous forme de chambre de passage avec une admission (40) et une évacuation (42), chambres à travers lesquelles les éléments de surface (4) sont transportés à l'aide d'un dispositif de transport (14, 16).

23. Dispositif selon la revendication 22, caractérisé par un dispositif à buses (44 ou 46), disposé près de l'admission (40), pour le premier, et près de l'évacuation (42), pour le deuxième, de la chambre de passage, où au moyen des deux groupes à buses est chaque fois expulsé de l'air, et un voile d'air étant produit de ce fait à l'entrée et à l'évacuation.

24. Dispositif selon l'une des revendications 20 à 23, caractérisé en ce que le dispositif de chauffage est formé par le dispositif de brasage (48).

25. Dispositif selon la revendication 24, en liaison avec la revendication 22 ou 23, caractérisé en ce que le dispositif de brasage (48) est disposé près de l'évacuation (42) de la chambre de passage et en ce que le dispositif de transport (14, 16) transporte les éléments de surface (4) hors de la chambre de passage et à travers le dispositif de brasage.

26. Dispositif selon la revendication 24 ou 25, caractérisé en ce que le dispositif de brasage (48) est un dispositif de brasage à la vague, produisant au moins une vague stationnaire de brasure, avec laquelle les surfaces destinées au raccordement par brasage sont placées en contact.

27. Dispositif selon la revendication 26, caractérisé en ce qu'au dispositif de brasage (48) est associé à un dispositif de soufflage de gaz protecteur, au moyen du quel les points de brasage sont exposés, directement après le processus de brasage, à un gaz protecteur, en particulier à de l'azote.

28. Dispositif selon la revendication 24 ou 25, caractérisé en ce que le dispositif de brasage est un dispositif de brasage de type reflow.

29. Dispositif selon l'une des revendications 20 à 28, caractérisé en ce que la chambre d'humidification (38) sert en même temps de chambre de processus pour un prétraitement au plasma des surfaces destinées au raccordement par brasage, et en ce que, dans la chambre d'humidification (38), peut être établie à volonté l'atmosphère gazeuse ou une atmosphère de gaz de processus pour le prétraitement par plasma.

30. Dispositif selon l'une des revendications 20 à 28, caractérisé en ce que le dispositif de décapage présente, en plus de la chambre d'humidification (38), une chambre de processus (26), pour le prétraitement au plasma des surfaces destinées au raccordement par brasage.

31. Dispositif selon la revendication 30, caractérisé en ce que la chambre de processus (26) est une chambre de processus à basse pression.

32. Dispositif selon la revendication 30 ou 31, caracterisé en ce que la chambre de processus (26) est réalisée sous forme de chambre de passage avec une admission et une évacuation, chambre à travers laquelle les éléments de surface (4) sont transportés à l'aide d'un dispositif transporteur (10).

33. Dispositif selon la revendication 32, en liaison avec la revendication 22 ou 23, caractérisé en ce qu'entre la chambre de processus (26) et la chambre d'humidification (38) est disposée une chambre d'aération (32), dans laquelle s'effectue une aeration des éléments de surface (4) prétraités au plasma avec un air exempt d'hydrocarbure, la chambre de processus (26), la chambre d'aération (32) et la chambre d'humidification (38) se suivant directement les unes à la suite des autres dans cet ordre et les espaces intérieurs de ces trois chambres étant chacun susceptibles d'être isolés les uns des autres au moyen d'un sas (22, 28, 34).
